(19) **Europäisches Patentamt / European Patent Office / Office européen des brevets**

(11) **EP 2 887 076 B1**

(12) **FASCICULE DE BREVET EUROPEEN**

(45) Date de publication et mention
de la délivrance du brevet:
**29.03.2023 Bulletin 2023/13**

(21) Numéro de dépôt: **14199532.4**

(22) Date de dépôt: **22.12.2014**

(51) Classification Internationale des Brevets (IPC):
***G01R 15/18*** *(2006.01)*

(52) Classification Coopérative des Brevets (CPC):
**G01R 15/181**

(54) **Capteur de courant à boucle de Rogowski et procédé de fabrication d'un tel capteur de courant**

Stromsensor mit Rogowskispule, und Herstellungsverfahren eines solchen Stromsensors

Current sensor with Rogowski coil and a method for manufacturing such a current sensor

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2013 FR 1363463**

(43) Date de publication de la demande:
**24.06.2015 Bulletin 2015/26**

(73) Titulaire: **Schneider Electric Industries SAS
92500 Rueil-Malmaison (FR)**

(72) Inventeurs:
• **STEPANEK, Jiri
38050 GRENOBLE Cedex 09 (FR)**
• **TIAN, Simon
38050 GRENOBLE Cedex 09 (FR)**
• **SINTHOMEZ, Daniel
38050 GRENOBLE Cedex 09 (FR)**

(74) Mandataire: **Lavoix
62, rue de Bonnel
69448 Lyon Cedex 03 (FR)**

(56) Documents cités:
**EP-A1- 1 073 908       EP-A1- 2 009 453
WO-A1-2005/119274       FR-A1- 2 943 792
JP-A- 2003 139 802      JP-A- 2011 252 751
US-A- 4 799 005         US-A- 5 012 218
US-A1- 2013 257 412**

• **MARIO CHIAMPI ET AL: "Evaluation of Flexible Rogowski Coil Performances in Power Frequency Applications", IEEE TRANSACTIONS ON INSTRUMENTATION AND MEASUREMENT, IEEE SERVICE CENTER, PISCATAWAY, NJ, US, vol. 60, no. 3, 1 March 2011 (2011-03-01), pages 854-862, XP011334540, ISSN: 0018-9456, DOI: 10.1109/TIM.2010.2060223**

**EP 2 887 076 B1**

## Description

La présente invention concerne un capteur de courant à boucle de Rogowski et un procédé de fabrication d'un tel capteur.

Le capteur de courant à boucle de Rogowski est propre à être positionné autour d'un conducteur électrique et à mesurer un courant circulant dans un tel conducteur électrique. Les capteurs de courant à boucle de Rogowski connus comportent un enroulement principal disposé autour du conducteur électrique. Selon le théorème d'Ampère et la loi de Faraday, si l'enroulement principal forme une boucle fermée autour du conducteur, il restitue un signal proportionnel à la dérivée du courant circulant dans le conducteur électrique.

L'un des intérêts du capteur de courant à boucle de Rogowski est qu'il comprend un mécanisme de fermeture propre à relier deux extrémités de l'enroulement principal. Plus précisément, le mécanisme de fermeture est mobile par rapport à l'une des extrémités entre une position fermée et respectivement une position ouverte, dans lesquelles l'enroulement principal et le mécanisme de fermeture forment une boucle fermée autour du conducteur électrique et respectivement une boucle ouverte. Le capteur de courant à boucle de Rogowski est donc propre à être facilement positionné autour du conducteur électrique ou au contraire écarté du conducteur électrique.

Cependant, la zone de fermeture de l'enroulement principal, c'est-à-dire la zone ou les deux extrémités sont reliées, est critique dans le sens où elle créée une discontinuité dans l'enroulement principal. En effet, en position fermée du mécanisme de fermeture, un espace existe entre les deux extrémités de l'enroulement principal. La présence de cet espace, ou discontinuité, implique une erreur dans la mesure réalisée par le capteur de courant. L'erreur de mesure par rapport à la mesure que fournirait un capteur parfait est plus ou moins importante, suivant la position relative du capteur de courant par rapport au conducteur électrique autour duquel il est disposé et par rapport au ou aux autres conducteurs électriques, disposés à proximité du capteur de courant, par exemple à moins de 5centimètres.

Dans le domaine des capteurs de courant à boucle de Rogowski, il est ainsi connu du document EP-A1-2 009 453 un capteur de courant à boucle de Rogowski, pour lequel le mécanisme de fermeture proposé est un corps magnétique ayant une grande perméabilité magnétique. Le corps magnétique est, par exemple, une ferrite et permet de créer un court-circuit magnétique, ce qui engendre une réduction de l'erreur de mesure du courant traversant le conducteur électrique, l'erreur étant liée à la zone de fermeture, c'est-à-dire à l'espace entre les deux extrémités de l'enroulement principal. Cependant, un tel capteur de courant à boucle de Rogowski est coûteux et complexe à fabriquer industriellement.

Il est également connu du document WO-A1-2005/119274 un capteur de courant comprenant un enroulement principal destiné à être positionné autour d'un conducteur électrique, l'enroulement principal comprenant deux extrémités, et un enroulement secondaire positionné entre les deux extrémités de l'enroulement principal. L'enroulement secondaire est bobiné autour d'un point fixe dans un unique plan, avec une augmentation de la distance du bobinage par rapport au point fixe au cours du bobinage. L'enroulement secondaire planaire permet de compenser l'erreur dans la mesure du courant due à l'espace entre les deux extrémités de l'enroulement principal. Cependant, les résultats donnés par une telle compensation restent insuffisants pour l'obtention d'une mesure de courant précise et une telle solution est complexe à mettre en oeuvre.

US 4, 799, 005 divulgue également un capteur de courant à boucle de Rogowski pour lequel la qualité de la mesure de courant reste à améliorer.

JP 2003 139802 décrit également un capteur de courant à boucle de Rogowski du type précité.

JP 2011 252751 décrit également un capteur de courant à boucle de Rogowski du type précité.

Le but de l'invention est donc de proposer un capteur de courant à boucle de Rogowski facile et peu coûteux à réaliser industriellement, pour lequel la mesure de courant est optimisée et l'erreur de mesure due à l'espace entre les deux extrémités de l'enroulement principal est réduite.

A cet effet, l'invention a pour objet un capteur de courant à boucle de Rogowski selon la revendication 1.

Grâce à l'invention, l'enroulement secondaire positionné entre les deux extrémités de l'enroulement principal, suivant l'axe longitudinal, est propre à être agencé dans un espace libre de bobinage entre les deux extrémités de l'enroulement principal. L'enroulement secondaire est alors propre à former, avec l'enroulement principal et en position fermée du mécanisme de fermeture, une boucle de bobinage globalement fermée et positionnée autour du conducteur électrique. L'utilisation de l'enroulement principal et de l'enroulement secondaire permet donc d'optimiser la mesure du courant, en limitant l'influence de l'espace libre de bobinage sur la mesure du courant. De plus, le capteur de courant proposé est peu coûteux et facile à réaliser industriellement.

Selon des aspects avantageux de l'invention, le capteur de courant est selon l'une quelconque des revendications 2 à 7.

L'invention a également pour objet un procédé de fabrication d'un capteur de courant à boucle de Rogowski selon la revendication 8.

Selon d'autres aspects avantageux de l'invention, le procédé de fabrication est selon l'une quelconque des revendications 9 à 12.

L'invention sera mieux comprise et d'autres avantages de celle-ci apparaitront plus clairement à la lumière de la description qui va suivre, donnée uniquement à titre d'exemple non limitatif, et faite en se référant aux dessins annexés sur lesquels :

- la figure 1 est une représentation schématique d'une installation électrique comprenant trois conducteurs électriques et trois capteurs de courant, chaque capteur étant conforme à un premier mode de réalisation de l'invention et disposé autour d'un conducteur électrique respectif ;
- la figure 2 est une vue partielle en perspective et en coupe d'un des capteurs de courant de la figure 1, suivant un plan Il visible à la figure 1, le capteur de courant comprenant un mécanisme de fermeture en position ouverte ;
- la figure 3 est une vue partielle et en perspective du capteur de courant de la figure 2 ;
- la figure 4 est une vue analogue à celle de la figure 2, sur laquelle le mécanisme de fermeture est en position fermée et un organe mobile est représenté dans une position de verrouillage du mécanisme de fermeture en position fermée.
- la figure 5 est une vue analogue à celle de la figure 4, sur laquelle l'organe mobile est dans une position de déverrouillage du mécanisme de fermeture en position fermée.
- la figure 6 est un organigramme d'un procédé de fabrication d'un capteur de courant conforme au premier mode de réalisation de l'invention,
- la figure 7 est une vue analogue à celle de la figure 4 selon un deuxième mode de réalisation de l'invention ;
- la figure 8 est vue analogue à celle de la figure 3 selon le deuxième mode de réalisation ;
- la figure 9 est une vue en perspective d'une liaison mécanique entre un enroulement principal et un enroulement secondaire du capteur de courant selon le deuxième mode de réalisation ;
- la figure 10 est une représentation très schématique de la position de deux extrémités de l'enroulement principal par rapport à l'enroulement secondaire, selon le deuxième mode de réalisation ;
- la figure 11 est un organigramme d'un procédé de fabrication selon le deuxième mode de réalisation de l'invention ;
- la figure 12 est une représentation analogue à celle de la figure 10 pour un capteur de courant conforme à un troisième mode de réalisation de l'invention ; et
- la figure 13 est une représentation analogue à celle de la figure 10 pour un capteur de courant conforme à un quatrième mode de réalisation de l'invention.

Dans la suite de la description, l'expression « sensiblement égal à » définit une relation d'égalité à plus ou moins 5 %.

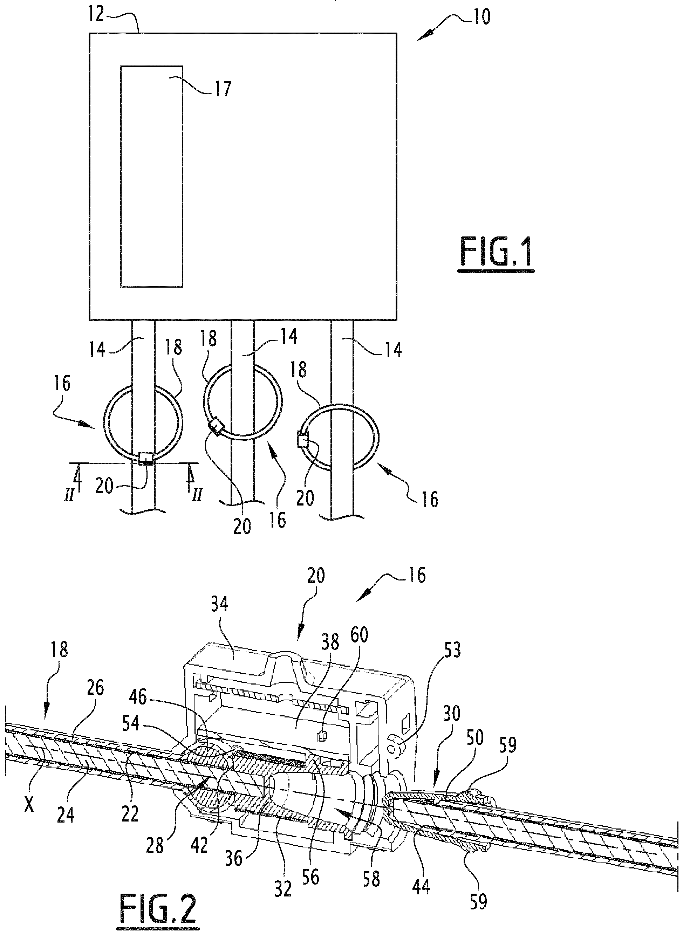

Sur la figure 1, une installation électrique 10 comprend une alimentation électrique 12, trois conducteurs électriques 14 formant un réseau électrique triphasé et trois capteurs de courant à boucle de Rogowski 16, chaque capteur 16 étant disposé autour d'un conducteur électrique 14 respectif.

L'alimentation électrique 12 comprend une unité de commande 17 et est propre, par exemple, à délivrer une basse tension, par exemple de valeur inférieure à 1000 Volts.

Chaque capteur de courant 16 forme une boucle autour du conducteur électrique 14 correspondant. Chaque capteur de courant 16 comprend un corps principal 18 flexible et un mécanisme de fermeture 20. Chaque corps principal 18 comprend un enroulement principal 22, un support de bobinage 24, une gaine 26 et des première 28 et deuxième 30 extrémités de fixation au mécanisme de fermeture 20, comme représenté sur la figure 2.

Le capteur de courant 16 comprend un enroulement secondaire 32, qui comporte une pluralité de spires décalées les unes par rapport aux autres suivant un axe longitudinal X.

Chaque mécanisme de fermeture 20 comprend un boîtier 34, à l'intérieur duquel sont disposés un corps central 36 et un circuit imprimé 38. Le mécanisme de fermeture 20 est propre à relier les première 28 et deuxième 30 extrémités de fixation.

L'enroulement principal 22 comporte des troisième 42 et quatrième 44 extrémités, positionnées respectivement à proximité des première 28 et deuxième 30 extrémités de fixation. L'enroulement principal 22 est bobiné autour du support de bobinage 24.

Le mécanisme de fermeture 20 est mobile par rapport à la quatrième extrémité 44, entre une position fermée et respectivement une position ouverte, dans lesquelles l'enroulement principal 22 et le mécanisme de fermeture 20 forment une boucle fermée autour de conducteur électrique 14 et respectivement une boucle ouverte. Ainsi, en position fermée du mécanisme de fermeture 20, les première 28 et deuxième 30 extrémités, de même que les troisième 42 et quatrième 44 extrémités, sont disposées suivant l'axe longitudinal X du mécanisme de fermeture 20 et distantes l'une de l'autre suivant cet axe.

La gaine 26 est, de préférence, une gaine thermo-rétractable qui s'étend, globalement depuis la troisième extrémité 42 jusqu'à la quatrième extrémité 44, autour de l'enroulement principal 22.

La première extrémité 28 de fixation comprend un tore 46 de maintien propre à être positionné à l'intérieur du boîtier 34, pour maintenir en position la première extrémité 28 par rapport au boîtier 34 et, plus généralement, par rapport au mécanisme de fermeture 20. A la figure 2, il apparait que la première extrémité 28 de fixation est fixée au corps central 36.

Les première 28 et deuxième 30 extrémités de fixation, de même que les troisième 42 et quatrième 44 extrémités, sont, à la figure 2, disposées suivant l'axe longitudinal X du mécanisme de fermeture 20 et du corps central 36.

La deuxième extrémité 30 comprend un embout de fixation 50, qui entoure la quatrième extrémité 44. L'embout de fixation 50 est propre à être inséré dans le corps central 36. La deuxième extrémité 30 est amovible par rapport au corps central 36 et au mécanisme de fermeture 20.

L'enroulement secondaire 32 est disposé autour du corps central 36. L'enroulement secondaire 32 est connecté électriquement en série avec l'enroulement principal 22. L'enroulement secondaire 32 a un nombre de spires par unité de longueur compris entre 0,1 et 25 spires par millimètre et par couche, de préférence entre 0,5 et 3 spires par millimètre et par couche. En effet, l'enroulement secondaire 32 est propre à comprendre une couche de spires, telle que présenté à la figure 2, ou, en variante, plusieurs couches de spires superposées les unes aux autres autour du corps central 36.

Plus précisément, l'enroulement principal 22 et l'enroulement secondaire 32 sont en forme de premier et deuxième tubes, et on obtient le rapport $\alpha$ suivant entre l'enroulement principal 22 et l'enroulement secondaire 32 :

$$\alpha = S1*N1*L2/(L1*S2*N2) = 1, \quad \text{(Equation 1)},$$

avec S1 représentant la section du premier tube, suivant un plan perpendiculaire au premier tube,

N1 représentant le nombre de spires de l'enroulement principal 22,

L1 représentant la longueur de l'enroulement principal 22,

S2 représentant la section du deuxième tube, suivant un plan perpendiculaire à l'axe longitudinal X,

N représentant le nombre de spires de l'enroulement secondaire 32 et

L2 représentant la longueur mesurée suivant l'axe longitudinal X, de l'enroulement secondaire 32.

Le rapport $\alpha$ est compris entre 0,9 et 1,1.

La longueur de l'enroulement secondaire 32, mesurée suivant l'axe longitudinal X, est comprise entre 2 millimètres (mm) et 60 mm, de préférence entre 5 mm et 15 mm.

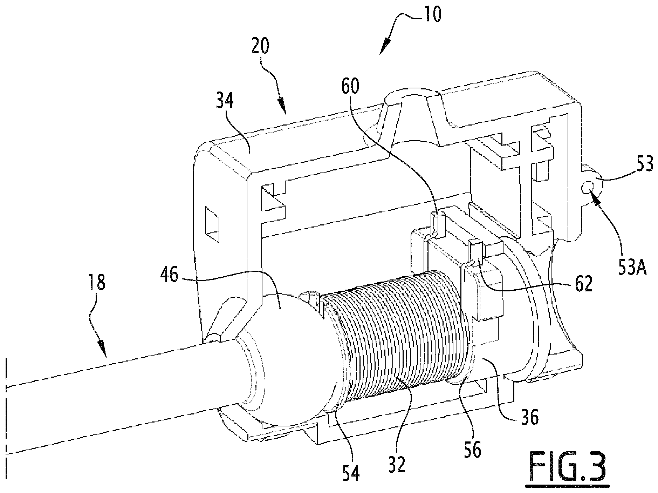

Le diamètre des spires de l'enroulement secondaire 32 est supérieur ou égal au diamètre des spires de l'enroulement principal 22. Aux figures 2 et 3, le diamètre des spires de l'enroulement secondaire 32 est compris entre 200 % et 300 % du diamètre des spires de l'enroulement principal 22.

En variante, le nombre de spires par unité de longueur au niveau des extrémités 42, 44 de l'enroulement principal 22 est supérieur au nombre de spires par unité de longueur sur le reste de l'enroulement principal 22.

Le boîtier 34 a une largeur minimale $L_{min}$, mesurée perpendiculairement à l'axe longitudinal X, supérieure à 120 % du diamètre maximal du corps central 36, mesuré radialement à l'axe longitudinal X.

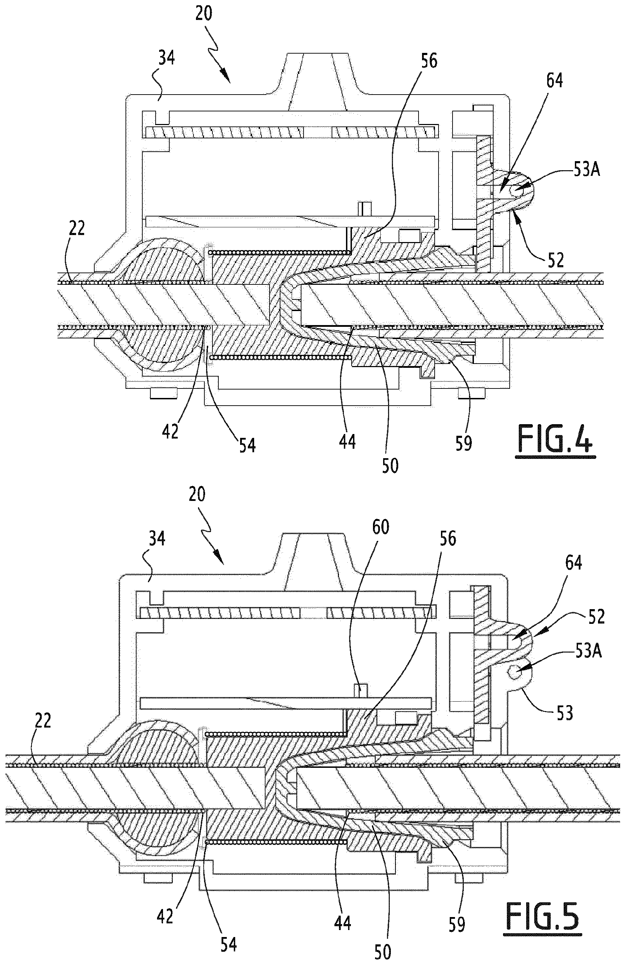

En complément, et comme présenté aux figures 4 et 5, le boîtier 34 comprend un organe mobile 52 propre à être déplacé, lorsque le mécanisme de fermeture 20 est en position fermée, entre une position de verrouillage du mécanisme de fermeture 20 en position fermée, visible à la figure 4, et une position de déverrouillage de la position fermée du mécanisme de fermeture 20, visible à la figure 5. Le boîtier 34 comprend également une protubérance 53 en saillie de celui-ci et munie d'un premier trou 53A traversant.

Le corps central 36 comprend des premier 54 et deuxième 56 rebords, entre lesquels s'étend l'enroulement secondaire 32. Les diamètres des premier 54 et deuxième 56 rebords, mesurés radialement à l'axe longitudinal X, sont supérieurs au diamètre maximal de l'enroulement secondaire 32 mesuré également radialement à l'axe longitudinal X.

Le corps central 36 comprend un orifice 58 de réception de l'embout 50 et de la deuxième extrémité 30, à l'intérieur duquel l'embout 50 est apte à être immobilisé en position fermée du mécanisme de fermeture 20. Le corps central 36 comprend également deux bornes 60, 62 de connexion au circuit 38.

Le circuit imprimé 38 est connecté aux bornes 60, 62.

En complément, le boîtier 34 intègre un module de traitement, non représenté, connecté aux bornes 60, 62 de connexion et propre à déterminer l'intensité du courant circulant à travers le conducteur électrique 14 autour duquel est disposé le capteur 16, en fonction du courant circulant à travers l'enroulement principal 22 et l'enroulement secondaire 32.

En position fermée du mécanisme de fermeture 20, la distance mesurée suivant l'axe longitudinal X, entre la troisième extrémité 42 de l'enroulement principal et une extrémité de l'enroulement secondaire 32 est inférieure à 1,5 mm. De manière analogue, en position fermée du mécanisme de fermeture 20, la distance mesurée suivant l'axe longitudinal X entre la quatrième extrémité 44 de l'enroulement principal et l'autre extrémité de l'enroulement secondaire est inférieure à 1,5 mm.

Le tore de maintien 46 est propre à être positionné à l'intérieur du boîtier 34, plus précisément entre une paroi du boîtier 34 et le corps central 36, suivant l'axe longitudinal X. Le tore 46 est propre à maintenir la première extrémité de fixation 28 à l'intérieur du boîtier 24, c'est-à-dire à maintenir la position de la troisième extrémité 42 par rapport à l'enroulement secondaire 32.

Le tore 46 permet de limiter une modification de la position des première 28 et troisième 42 extrémités par rapport au corps central 36, lorsqu'un effort est exercé sur le corps principal 18 pour déplacer la première extrémité 28 et la troisième extrémité 42, suivant l'axe longitudinal X.

L'embout de fixation 50 a une forme globalement tronconique, complémentaire de celle de l'orifice 58. L'embout 50, est immobilisé par rapport au mécanisme de fermeture 20 par une fonction élastique se trouvant sur l'embout de fixation 50. En outre, l'embout 50 comprend un épaulement 59, propre à être coincé dans l'orifice 58, en configuration fermée du mécanisme de fermeture, l'épaulement 59 étant de révolution autour de l'axe longitudinal X et présentant une section triangulaire dans un plan vertical comportant l'axe longitudinal X.

L'organe mobile 52 comprend un deuxième trou traversant 64, qui est aligné avec le premier trou traversant 53A lorsqu'il est en position de verrouillage du mécanisme de fermeture en position fermée. L'organe mobile 52 est propre, en position fermée du mécanisme de fermeture 20 et dans sa position de verrouillage, visible sur la figure 4, à venir obstruer une partie de l'orifice 58 pour maintenir le mécanisme de fermeture 20 en position fermée, c'est à dire la deuxième extrémité 30, la quatrième extrémité 44 et l'embout 50, à l'intérieur de l'orifice 58. De la même manière, lorsqu'il est en position de déverrouillage, visible sur la figure 5, et que le mécanisme de fermeture est en position fermée, l'organe mobile 52 libère l'orifice 58 et le mécanisme de fermeture 20 est propre à être déplacé en position ouverte suite à l'application d'un effort afin de retirer la deuxième extrémité 30, et donc l'embout de fixation 50, de l'orifice 58.

Avantageusement, en position fermée du mécanisme de fermeture 20 et en position de verrouillage de l'organe mobile 52, un mécanisme de plombage, non représenté, tel qu'un fil dont les deux extrémités sont reliées par un plomb, est apte à être inséré à travers les trous traversants 53A et 64, afin de bloquer l'organe mobile 52 dans sa position de verrouillage du mécanisme de fermeture 20 en position fermée.

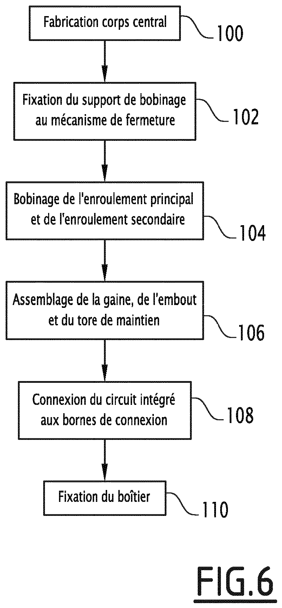

La figure 6 présente un procédé de fabrication du capteur de courant 16.

Lors d'une première étape 100, le corps central 36 est fabriqué. Puis, au cours d'une étape 102 de fixation, le support de bobinage 24 est fixé au mécanisme de fermeture 20. Plus précisément, une extrémité du support de bobinage 24 correspondant à la première extrémité 28 est fixée au mécanisme de fermeture 20.

Ensuite, lors d'une étape 104 de bobinage de l'enroulement principal 22 et de l'enroulement secondaire 32, un premier fil est bobiné de manière continue, dans un premier sens, depuis l'une des bornes 60 de connexion, afin de former successivement l'enroulement principal 22 et l'enroulement secondaire 32. Lors de l'étape de bobinage 104, la dernière extrémité de l'enroulement principal 22 formée, c'est-à-dire la quatrième extrémité 44 de l'enroulement principal 22, est connectée à l'autre borne de connexion 62. Plus précisément, une fois que la quatrième extrémité 44 est formée, le premier fil est bobiné de manière continue dans un deuxième sens, opposé au premier sens, afin d'augmenter le nombre de spires des enroulements principal 22 et secondaire 32, et le premier fil est ensuite connecté à l'autre borne de connexion 62.

En variante, un élément conducteur est disposé à travers le corps principal 18, et plus précisément à travers le support de bobinage 24, et lors de l'étape de bobinage 104, un premier fil est bobiné de manière continue, dans un premier sens, depuis l'une des bornes 60 de connexion, afin de former successivement l'enroulement principal 22 et l'enroulement secondaire 32. Puis, la quatrième extrémité 44 de l'enroulement principal 22 est connectée à l'élément conducteur, qui relie alors la quatrième extrémité 44 à ladite autre borne de connexion 62. L'élément conducteur est par exemple un fil de cuivre.

Lors d'une étape 106, le tore de maintien 46 est formé, la gaine 26 est positionnée autour de l'enroulement principal 22 et l'embout 50 est fixé sur la deuxième extrémité 30. Puis, lors d'une étape suivante 108, le circuit imprimé 38 est connecté aux bornes de connexion 60, 62.

Ensuite, au cours d'une étape 110 de fixation, le boîtier 34 est positionné autour du corps central 36 et de l'enroulement secondaire 32, ainsi que du circuit imprimé 38, afin de former le mécanisme de fermeture 20.

Le procédé de fabrication présenté ci-dessus permet un bobinage simplifié du capteur de courant 16, puisque les enroulements principal 22 et secondaire 32 sont formés à partir du même fil.

De plus, la distance entre, d'une part, les troisième 42 et quatrième 44 extrémités et, d'autre part, l'enroulement secondaire 32 est inférieure à 1,5 mm. Ainsi, la distance entre les enroulements principal 22 et secondaire 32 est minimisée.

Avantageusement, le rapport entre le diamètre de l'enroulement principal 22 et le diamètre de l'enroulement secondaire 32 est inférieur à 300%. Ainsi, une ouverture s'étendant dans des directions perpendiculaire et parallèle à l'axe longitudinal X entre, d'une part, les troisième 42 et quatrième 44 extrémités et, d'autre part, l'enroulement secondaire 32 est réduite, ce qui permet d'améliorer la mesure du courant circulant à travers le conducteur électrique 14 correspondant.

L'enroulement secondaire 32 est disposé dans un espace libre de bobinage de l'enroulement principal 22, qui s'étend, suivant l'axe longitudinal X, entre les troisième 42 et quatrième 44 extrémités et permet de créer une continuité de bobinage avec l'enroulement principal 22, afin d'améliorer la mesure du courant circulant à travers le conducteur électrique 14.

Le mécanisme de fermeture 20 est mobile par rapport à la quatrième extrémité 44, ce qui permet de positionner le capteur de courant 16 autour de l'un des conducteurs électriques 14 et de le déplacer autour d'un autre conducteur électrique 14.

Les premier 54 et deuxième 56 rebords permettent de mieux maintenir le bobinage secondaire 32 autour du corps central 36.

La forme tronconique de l'embout 50 permet d'assurer un meilleur positionnement mécanique de l'embout 50 dans l'orifice 58. L'épaulement 59 permet d'offrir un meilleur maintien de l'embout 50 dans l'orifice 58, en position fermée du mécanisme de fermeture 20.

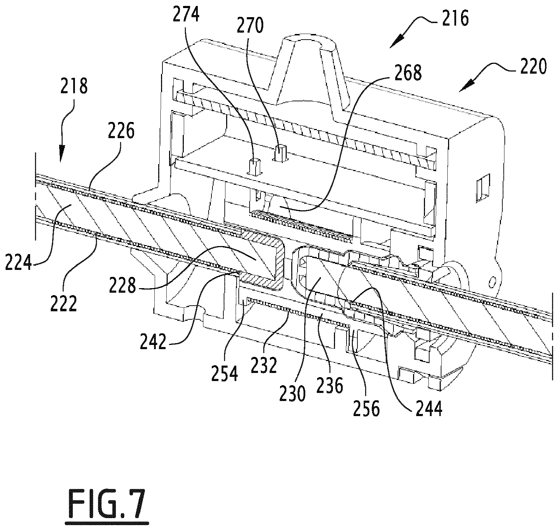

Dans un deuxième mode de réalisation, représenté aux figures 7 à 10, les éléments similaires à ceux du premier mode de réalisation portent les mêmes références augmentées de 200. Ainsi, un capteur de courant 216 comprend un corps principal 218 et un mécanisme de fermeture 220.

Chaque corps principal 218 comprend un enroulement principal 222, un support 224 de bobinage, une gaine 226 et des première 228 et deuxième 230 extrémités de fixation au mécanisme de fermeture 220.

De plus, chaque mécanisme de fermeture 220 comprend un boîtier 234 à l'intérieur duquel sont disposés un corps central 236 et un circuit imprimé 238. Un enroulement secondaire 232 est positionné autour du corps central 236.

Le mécanisme de fermeture 220 et le corps central 236 s'étendent suivant l'axe longitudinal X.

Dans la suite, seules les différences entre les premier et deuxième modes de réalisation seront présentées.

Le support de bobinage 224 et, plus précisément le corps principal 218, comprend, au niveau de la première extrémité 228, un élément 268 comprenant une première 270 et une deuxième 272 bornes de connexion de l'enroulement principal 222. Plus précisément, l'enroulement principal 222 comprend des troisième 242 et quatrième 244 extrémités et est bobiné depuis la première borne de connexion 270, jusqu'à la deuxième extrémité 230 et depuis la deuxième extrémité 230 jusqu'à la deuxième borne de connexion 272. Ainsi, la quatrième extrémité 244 est connectée à la deuxième borne de connexion 272.

Le corps central 236 comprend des troisième 274 et quatrième 276 bornes de connexion de bobinages. De plus, l'enroulement secondaire 232 est connecté entre les troisième 274 et quatrième 276 bornes de connexion, et s'étend entre un premier rebord 254 recevant les troisième 274 et quatrième 276 bornes de connexion et un deuxième rebord 256.

Ainsi, le capteur de courant 216 comprend quatre bornes de connexion 270, 272, 274, 276. Les quatre bornes de connexion 270, 272, 274, 276 sont sensiblement alignées les unes par rapport aux autres, suivant un plan perpendiculaire à l'axe longitudinal X.

Le circuit imprimé 238 est propre à relier la deuxième borne 272 à la quatrième borne 274, pour connecter l'enroulement principal 222 et l'enroulement secondaire 232 en série.

Une unité de traitement, non représentée, est connectée entre les première 270 et troisième 274 bornes de connexion et est propre à mesurer le courant traversant le conducteur électrique correspondant, lorsque le mécanisme de fermeture 220 est en position fermée.

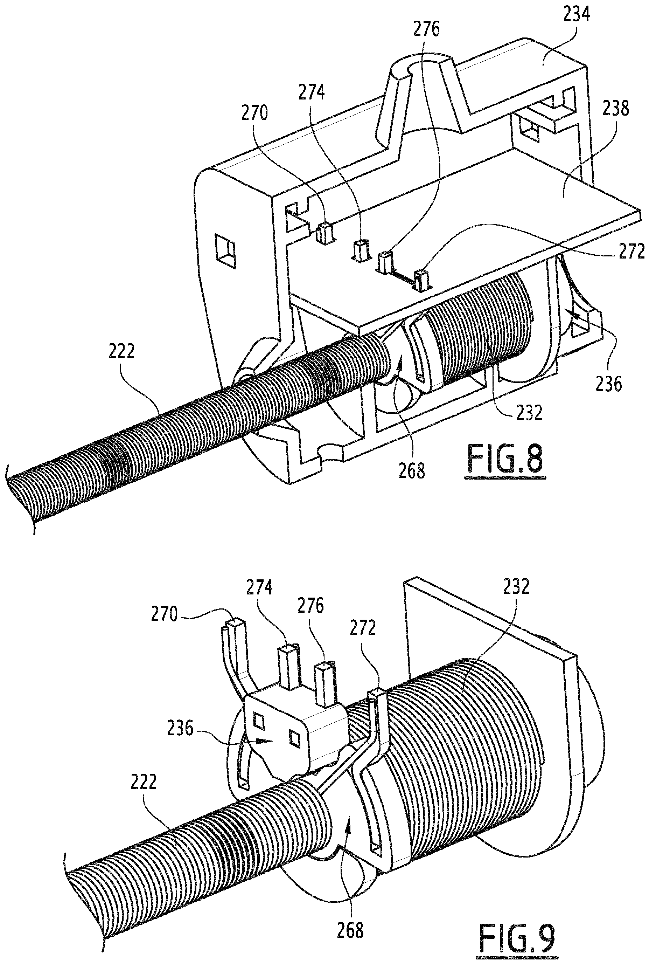

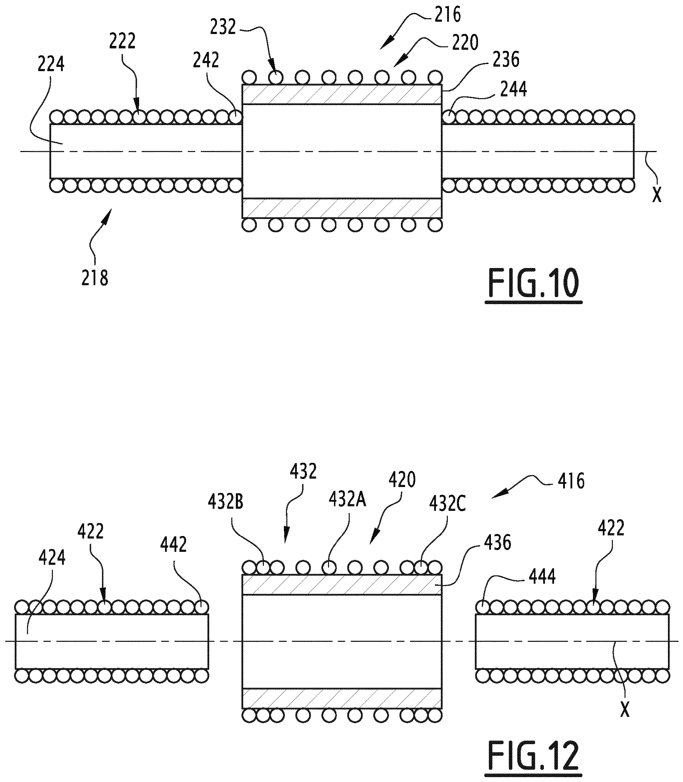

Comme représenté aux figures 8 et 9, les bornes 270, 272, 274, 276 sont sensiblement alignées et, comme visible à la figure 10, la distance mesurée suivant l'axe longitudinal X entre la troisième extrémité 242 et une extrémité de l'enroulement secondaire 232 est sensiblement nulle. De plus, sur la figure 10, la distance mesurée suivant l'axe longitudinal X entre la quatrième extrémité 244 et l'autre extrémité de l'enroulement secondaire 232 est également sensiblement nulle.

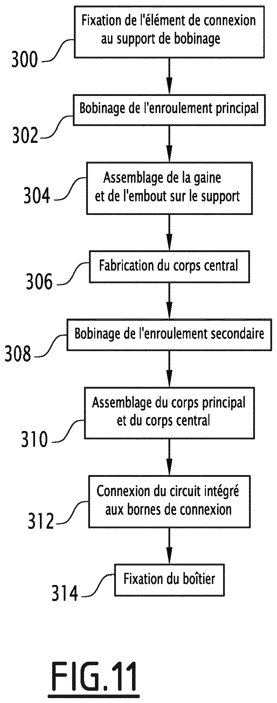

Un procédé de fabrication du capteur de courant 216 est présenté à la figure 11.

Une première étape 300 consiste en l'assemblage de l'élément de connexion 268 avec le support de bobinage 224. Puis, lors d'une étape 302, l'enroulement principal 222 est bobiné, et ses extrémités 242, 244 sont respectivement connectées aux première 270 et deuxième 272 bornes de connexion. Plus précisément un premier fil est bobiné, dans un premier sens de l'axe X, autour du support de bobinage 224, depuis la première borne de connexion 270, jusqu'à former l'enroulement principal et notamment les troisième 242 et quatrième 244 extrémités. Puis, une fois la quatrième extrémité formée, le premier fil est bobiné dans un deuxième sens de l'axe X, opposé au premier sens, afin d'augmenter le nombre de spires de l'enroulement principal 222, et est ensuite connecté à la deuxième borne 272.

En variante, le support de bobinage 224 est traversé par un élément conducteur, qui relie la quatrième extrémité 244 et la deuxième borne 272.

Ensuite, au cours d'une étape 304, la gaine 226 est positionnée autour de l'enroulement principal 222 et l'embout de fixation 250 est fixé sur l'extrémité 230. Puis, lors d'une étape 306, le corps central 236 est fabriqué.

Lors d'une étape suivante 308, un deuxième fil est bobiné autour du corps central 236, afin de former l'enroulement secondaire 232. Le deuxième fil est bobiné, dans un premier sens, depuis la troisième borne de connexion 274 jusqu'au deuxième rebord 256 et, dans un deuxième sens, opposé au premier sens, depuis le deuxième rebord 256 jusqu'à la quatrième borne de connexion 276. L'enroulement secondaire 232 est ainsi connecté entre les troisième 274 et quatrième 276 bornes de connexion.

Au cours d'une étape 310 d'assemblage, le corps principal 218, et plus précisément la première extrémité 228, est assemblé avec le corps central 236 de manière à ce que les première 270, deuxième 272, troisième 274 et quatrième 276 bornes de connexion soient sensiblement disposées préférentiellement dans un même plan perpendiculaire à l'axe longitudinal X.

Ensuite, lors d'une étape 312, le circuit imprimé 238 est positionné de façon à ce que les bornes de connexion 270, 272, 274, 276, le traversent afin de connecter entre elles les deuxième 272 et quatrième 274 bornes de connexion. Enfin, au cours d'une étape 314, le boîtier 234 est fixé autour du corps central 236 et du circuit imprimé 238.

Lors des étapes de bobinage 302, 308 de l'enroulement principal 222 et de l'enroulement secondaire 232, et plus précisément, lors du bobinage dans le premier sens puis dans le deuxième sens, le diamètre des spires bobinées pour le premier sens et le diamètre des spires bobinées pour le deuxième sens sont identiques. En variante, le diamètre de spires bobinées pour le premier sens et le diamètre des spires bobinées pour le deuxième sens sont différents.

Les avantages présentés pour le premier mode de réalisation s'appliquent au deuxième mode de réalisation. Le capteur de courant 216 permet d'améliorer la mesure du courant circulant dans le conducteur électrique correspondant, puisque grâce à l'utilisation des quatre bornes 270, 272, 274, 276, la distance entre la troisième extrémité 242 et l'enroulement secondaire 232 est nulle, ce qui permet de réduire la taille de l'ouverture présentée dans la description du premier mode de réalisation.

A la figure 12, un troisième mode de réalisation de l'invention est représenté et les éléments similaires à ceux du premier mode de réalisation portent les mêmes références augmentées de 400.

Dans la suite, seules les différences entre le troisième mode de réalisation et le premier mode de réalisation seront présentées. Ainsi, un capteur de courant 416 comprend un mécanisme de fermeture 420 et un corps principal 418. Le corps principal 418 comprend un enroulement principal 416. Le mécanisme de fermeture 420 comprend un corps central 436 autour duquel est disposé un enroulement secondaire 432. La figure 12 correspond à la position fermée du mécanisme de fermeture 420. La distance, mesurée suivant l'axe longitudinal X, entre la troisième extrémité 442 et une extrémité de l'enroulement secondaire 432, est supérieure à 1 mm. De manière analogue, la distance mesurée suivant l'axe longitudinal X entre la quatrième extrémité 444 et l'autre extrémité de l'enroulement secondaire 432 est supérieure à 1mm.

L'enroulement secondaire 432 n'a pas le même nombre de spires par unité de longueur sur toute sa longueur. L'enroulement secondaire 432 comprend, suivant l'axe longitudinal X, une partie centrale 432A et des première 432B et deuxième 432C parties distales. Les parties distales 432B et 432C comprennent alors un nombre de spires par unité de longueur supérieur au nombre de spires par unité de longueur de la partie centrale 432A. La longueur, mesurée suivant l'axe longitudinal X, des parties distales 432B et 432C est par exemple comprise entre 5 % et 100 % de la longueur de la partie centrale 432A.

Les avantages présentés pour le premier mode de réalisation s'appliquent au troisième mode de réalisation.

Le capteur de courant 416 et plus précisément l'enroulement secondaire 432 comprend donc des spires de compensation au niveau des parties distales 432B et 432C, qui permettent de réduire encore l'erreur dans la mesure du courant, liée à une ouverture qui s'étend perpendiculairement et parallèlement à l'axe longitudinal X entre, d'une part, les troisième 442 et quatrième 444 extrémités et, d'autre part, l'enroulement secondaire 432.

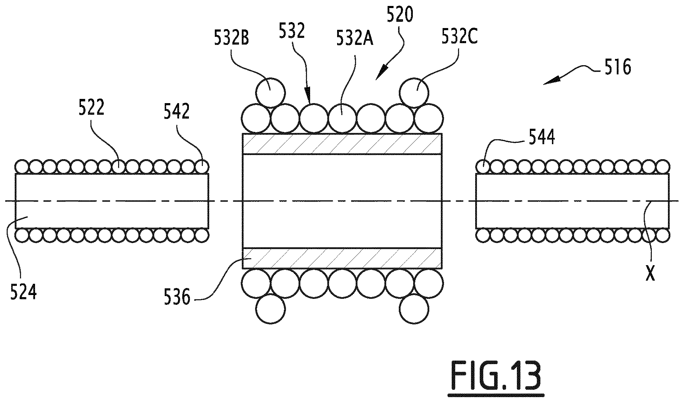

La figure 13 correspond à un quatrième mode de réalisation de l'invention, dans lequel les éléments similaires à ceux du troisième mode de réalisation portent les mêmes références augmentées de 100.

Selon le quatrième mode de réalisation, un enroulement secondaire 532 est formé à partir d'un fil, dont le diamètre est tel que l'espace entre des spires consécutives, mesuré suivant l'axe longitudinal X, est sensiblement nul. Le diamètre est par exemple égal à 1,2 mm.

Ainsi, cette configuration permet de limiter un déplacement des spires de l'enroulement secondaire 532, suivant l'axe longitudinal X. De plus, dans ce quatrième mode de réalisation, l'enroulement secondaire 532 comprend une partie centrale 532A et deux parties distales 532B et 532C, et le nombre de spires par unité de longueur des parties distales 532B, 532C est supérieur au nombre de spires par unité de longueur de la partie centrale 532A. En complément, le diamètre des spires des parties distales 532B, 532C est différent suivant les spires. En effet certaines spires des parties distales 532B, 532C, sont superposées sur d'autres spires desdites parties distales.

Les avantages présentés pour le troisième mode de réalisation s'appliquent au quatrième mode de réalisation. Le capteur de courant 516 permet de limiter un déplacement des spires de l'enroulement secondaire 532, suivant l'axe longitudinal X, et par conséquent, de mieux maintenir le bobinage secondaire 532 autour du corps central 536.

**Revendications**

1. Capteur de courant (16 ; 216 ; 416 ; 516) à boucle de Rogowski, destiné à mesurer un courant circulant dans un conducteur électrique (14), le capteur de courant comprenant :

   - un enroulement principal (22 ; 222 ; 422 ; 522) comportant deux extrémités (42, 44 ; 242, 244 ; 442, 444 ; 542, 544),
   - un mécanisme de fermeture (20 ; 220 ; 420 ; 520) propre à relier une extrémité (42 ; 242 ; 442 ; 542) de l'enroulement principal à l'autre extrémité (44 ; 244 ; 444 ; 544), le mécanisme de fermeture étant mobile par rapport à l'une des extrémités (44 ; 244 ; 444 ; 544) entre une position fermée et une position ouverte, dans lesquelles l'enroulement principal (22 ; 222 ; 422 ; 522) et le mécanisme de fermeture (20 ; 220 ; 420 ; 520) forment une boucle fermée autour du conducteur électrique (14) et respectivement une boucle ouverte, les deux extrémités (42, 44 ; 242, 244 ; 442, 444 ; 542, 544) étant, en position fermée du mécanisme de fermeture, disposées suivant un axe longitudinal (X) du mécanisme de fermeture (20 ; 220 ; 420 ; 520) et distantes l'une de l'autre suivant l'axe longitudinal (X), et
   - un enroulement secondaire (32 ; 232 ; 432 ; 532) disposé entre les extrémités (42, 44 ; 242, 244 ; 442, 444 ; 542, 544) de l'enroulement principal (22 ; 222 ; 422 ; 522), en position fermée du mécanisme de fermeture (20 ; 220 ; 420 ;

520),

l'enroulement secondaire (32 ; 232 ; 432 ; 532) comportant une pluralité de spires décalées les unes par rapport aux autres suivant l'axe longitudinal (X), le diamètre des spires de l'enroulement secondaire (32 ; 232 ; 432 ; 532) étant supérieur ou égal au diamètre des spires de l'enroulement principal (22 ; 222 ; 422 ; 522), **caractérisé en ce que**, en position fermée du mécanisme de fermeture (20 ; 220), la distance mesurée suivant l'axe longitudinal (X) entre chaque extrémité et l'enroulement secondaire (32 ; 232 ; 432 ; 532) est inférieure à 1,5 mm, et **en ce que** l'enroulement secondaire (432 ; 532) comprend, suivant l'axe longitudinal (X), une partie centrale (432A ; 532A) et des première (432B ; 532B) et deuxième (432C ; 532C) parties distales, et **en ce que** au moins l'une des partie distales (432B, 432C ; 532B, 532C) comprend un nombre de spires par unité de longueur supérieur au nombre de spires par unité de longueur de la partie centrale (432A ; 532A), la distance mesurée suivant l'axe longitudinal X entre une extrémité (442) de l'enroulement principal et une extrémité de l'enroulement secondaire (432) étant supérieur à 1 mm, et la distance mesurée suivant l'axe longitudinal X entre l'autre extrémité (444) de l'enroulement principal et l'autre extrémité de l'enroulement secondaire (432) étant supérieur à 1 mm.

2. Capteur selon la revendication 1, **caractérisé en ce que** le mécanisme de fermeture comprend un corps central (36 ; 236 ; 436 ; 536) autour duquel est disposé l'enroulement secondaire (32 ; 232 ; 432 ; 532), suivant l'axe longitudinal (X).

3. Capteur selon l'une des revendications précédentes, **caractérisé en ce que** l'enroulement principal (22 ; 222 ; 422 ; 522) est connecté électriquement en série de l'enroulement secondaire (32 ; 232 ; 432 ; 532).

4. Capteur selon l'une des revendications précédentes, **caractérisé en ce que** le nombre de spires par unité de longueur de l'enroulement secondaire (32 ; 232 ; 432 ; 532) est compris entre 0,1 et 25 spires par millimètre et par couche de spires, de préférence entre 0,5 et 3 spires par millimètre et par couche de spires.

5. Capteur selon l'une des revendications précédentes, **caractérisé en ce que** la longueur de l'enroulement secondaire (32 ; 232 ; 432 ; 532), mesurée suivant l'axe longitudinal (X), est comprise entre 2 mm et 60 mm, de préférence entre 5 mm et 15 mm.

6. Capteur selon la revendication 2, **caractérisé en ce que** le mécanisme de fermeture (20 ; 220 ; 420 ; 520) comprend un boîtier (34 ; 234), une largeur minimale (Lmin) du boîtier, mesurée radialement à l'axe longitudinal (X), étant supérieure à 120 % du diamètre maximal du corps central (36 ; 236 ; 436 ; 536), mesuré radialement à l'axe longitudinal (X).

7. Capteur selon l'une des revendications précédentes, **caractérisé en ce que** le mécanisme de fermeture (20 ; 220 ; 420 ; 520) comprend un boîtier (34 ; 234), le boîtier comprenant un organe mobile (52) propre à être déplacé, lorsque le mécanisme de fermeture (20 ; 220 ; 420 ; 520) est en position fermée, entre une position de verrouillage de la position fermée du mécanisme de fermeture (20 ; 220 ; 420 ; 520) et une position de déverrouillage de ladite position.

8. Procédé de fabrication d'un capteur de courant (16 ; 216 ; 416 ; 516) à boucle de Rogowski, destiné à mesurer un courant circulant dans un conducteur électrique, le procédé de fabrication comprenant les étapes suivantes :

- le bobinage (104 ; 302) d'un enroulement principal (22 ; 222 ; 422 ; 522) comportant deux extrémités (42, 44 ; 242, 244 ; 442, 444 ; 542, 544),
- la fabrication (100, 108, 110) d'un mécanisme de fermeture (20 ; 220 ; 420 ; 520) propre à relier une extrémité (42 ; 242 ; 442 ; 542) à l'autre extrémité (44 ; 244 ; 444 ; 544), le mécanisme de fermeture étant mobile par rapport à l'une des extrémités (44 ; 244 ; 444 ; 544) entre une position fermée et une position ouverte, dans lesquelles l'enroulement principal (22 ; 222 ; 422 ; 522) et le mécanisme de fermeture (20 ; 220 ; 420 ; 520) forment une boucle fermée autour du conducteur électrique (14) et respectivement une boucle ouverte, les deux extrémités (42, 44 ; 242, 244 ; 442, 444 ; 542, 544) étant, en position fermée du mécanisme de fermeture, disposées suivant un axe longitudinal (X) du mécanisme de fermeture (20 ; 220 ; 420 ; 520) et distantes l'une de l'autre suivant l'axe longitudinal (X), et
- le bobinage (104 ; 308) d'un enroulement secondaire (32 ; 232 ; 432 ; 532), disposé entre les extrémités de l'enroulement principal (22 ; 222 ; 422 ; 522), en position fermée du mécanisme de fermeture (20 ; 220 ; 420 ; 520), lors de l'étape de bobinage (104 ; 308) de l'enroulement secondaire, l'enroulement secondaire (32 ; 232 ; 432 ; 532) comprend une pluralité de spires décalées les unes par rapport aux autres suivant l'axe longitudinal (X), le diamètre des spires de l'enroulement secondaire (32 ; 232 ; 432 ; 532) étant est- supérieur ou égal au diamètre des spires de l'enroulement principal (22 ; 222 ; 422 ; 522),

**caractérisé en ce que**, en position fermée du mécanisme de fermeture (20 ; 220), la distance mesurée suivant l'axe longitudinal (X) entre chaque extrémité et l'enroulement secondaire (32 ; 232 ; 432 ; 532) est inférieure à 1,5 mm, et **en ce que** l'enroulement secondaire (432 ; 532) comprend, suivant l'axe longitudinal (X), une partie centrale (432A ; 532A) et des première (432B ; 532B) et deuxième (432C ; 532C) parties distales, et **en ce que** au moins l'une des partie distales (432B, 432C ; 532B, 532C) comprend un nombre de spires par unité de longueur supérieur au nombre de spires par unité de longueur de la partie centrale (432A ; 532A), la distance mesurée suivant l'axe longitudinal X entre une extrémité (442) de l'enroulement principal et une extrémité de l'enroulement secondaire (432) étant supérieur à 1 mm, et la distance mesurée suivant l'axe longitudinal X entre l'autre extrémité (444) de l'enroulement principal et l'autre extrémité de l'enroulement secondaire (432) étant supérieur à 1 mm.

9. Procédé selon la revendication 8, **caractérisé en ce que**,

- lors de l'étape de fabrication (100, 108, 110) du mécanisme de fermeture (20), le mécanisme de fermeture (20) est fabriqué avec deux bornes (60, 62) de connexion de bobinages et un corps central (36) autour duquel est destiné à être disposé l'enroulement secondaire (32).

10. Procédé selon la revendication 9, **caractérisé en ce que**,

- lors des étapes de bobinage (104) de l'enroulement principal et de l'enroulement secondaire, un fil est bobiné de manière continue, dans un premier sens, depuis l'une des bornes de connexion (60), afin de former successivement l'enroulement secondaire (32) et l'enroulement principal (22), et **en ce que** la dernière extrémité (44) de l'enroulement principal (22) formée est connectée à l'autre borne de connexion (62).

11. Procédé selon la revendication 10, **caractérisé en ce que** lorsque la dernière extrémité de l'enroulement principal (22) est formée, le fil est bobiné de manière continue dans un deuxième sens, opposé au premier sens, afin d'augmenter le nombre de spires des enroulements principal (22) et secondaire (32), puis connecté à ladite autre borne de connexion (62).

12. Procédé selon la revendication 8, **caractérisé en ce que**

- lors de l'étape de bobinage (302) de l'enroulement principal (222), un premier fil est bobiné et forme l'enroulement principal (222) avec chacune de ses extrémités (242, 244) connectées à une première (270) et à une deuxième (272) bornes de connexion de bobinages,

- lors de l'étape de fabrication (306, 312, 314) du mécanisme de fermeture (220), le mécanisme de fermeture (220) est fabriqué avec des troisième (274) et quatrième (276) bornes de connexion de bobinages et un corps central (236) autour duquel est destiné à être disposé l'enroulement secondaire (232),

- lors de l'étape de bobinage (308) de l'enroulement secondaire (232), un deuxième fil est bobiné autour du corps central (236), et l'enroulement secondaire (232) est connecté entre la troisième (274) et la quatrième (276) borne de connexion,

et **en ce que** le procédé comprend l'étape suivante :

- la connexion (312) de la deuxième borne de connexion (272) avec la quatrième borne de connexion (276).

**Patentansprüche**

1. Stromsensor (16; 216; 416; 516) mit Rogowski-Schleife zum Messen eines Stroms, der in einem elektrischen Leiter (14) fließt, der Stromsensor umfassend:

- eine Hauptwicklung (22; 222; 422; 522) umfassend zwei Enden (42, 44; 242, 244; 442, 444; 542, 544),

- einen Schließmechanismus (20; 220; 420; 520), der geeignet ist, um ein Ende (42; 242; 442; 542) der Hauptwicklung mit dem anderen Ende (44; 244; 444; 544) zu verbinden, wobei der Schließmechanismus in Bezug auf eines der Enden (44; 244; 444; 544) zwischen einer geschlossenen Position und einer offenen Position bewegbar ist, in denen die Hauptwicklung (22; 222; 422; 522) und der Schließmechanismus (20; 220; 420; 520) eine geschlossene Schleife um den elektrischen Leiter (14) und jeweils eine offene Schleife bilden, wobei die zwei Enden (42, 44; 242, 244; 442, 444; 542, 544) in der geschlossenen Position des Schließmechanismus entlang einer Längsachse (X) des Schließmechanismus (20; 220; 420; 520) angeordnet und entlang der Längsachse (X) voneinander beabstandet sind, und

- eine Sekundärwicklung (32; 232; 432; 532), die in der geschlossenen Position des Schließmechanismus (20; 220; 420; 520) zwischen den Enden (42, 44; 242, 244; 442, 444; 542, 544) der Primärwicklung (22; 222; 422; 522) angeordnet ist,

die Sekundärwicklung (32; 232; 432; 532) umfassend eine Vielzahl von Windungen, die entlang der Längsachse (X) gegeneinander versetzt sind, wobei der Durchmesser der Windungen der Sekundärwicklung (32; 232; 432; 532) größer als oder gleich wie der Durchmesser der Windungen der Hauptwicklung (22; 222; 422; 522) ist, **dadurch gekennzeichnet,**

**dass** in der geschlossenen Position des Schließmechanismus (20; 220) der entlang der Längsachse (X) gemessene Abstand zwischen jedem Ende und der Sekundärwicklung (32; 232; 432; 532) weniger als 1,5 mm ist, und

**dass** die Sekundärwicklung (432; 532) entlang der Längsachse (X) einen Mittelabschnitt (432A; 532A) und einen ersten (432B; 532B) und einen zweiten (432C; 532C) distalen Abschnitt umfasst, und dass mindestens einer der distalen Abschnitte (432B, 432C; 532B, 532C) eine Anzahl von Windungen pro Längeneinheit umfasst, die größer ist als die Anzahl von Windungen pro Längeneinheit des Mittelabschnitts (432A; 532A),

wobei der entlang der Längsachse X gemessene Abstand zwischen einem Ende (442) der Hauptwicklung und einem Ende der Nebenwicklung (432) größer ist als 1 mm, und

wobei der entlang der Längsachse X gemessene Abstand zwischen dem anderen Ende (444) der Hauptwicklung und dem anderen Ende der Nebenwicklung (432) größer ist als 1 mm.

2. Sensor nach Anspruch 1, **dadurch gekennzeichnet, dass** der Schließmechanismus einen mittleren Körper (36; 236; 436; 536) umfasst, um den die Sekundärwicklung (32; 232; 432; 532) entlang der Längsachse (X) angeordnet ist.

3. Sensor nach einem der vorherigen Ansprüche, **dadurch gekennzeichnet, dass** die Hauptwicklung (22; 222; 422; 522) mit der Sekundärwicklung (32; 232; 432; 532) elektrisch in Reihe geschaltet ist.

4. Sensor nach einem der vorherigen Ansprüche, **dadurch gekennzeichnet, dass** die Anzahl der Windungen pro Längeneinheit der Sekundärwicklung (32; 232; 432; 532) zwischen 0,1 und 25 Windungen pro Millimeter und pro Windungsschicht ist, vorzugsweise zwischen 0,5 und 3 Windungen pro Millimeter und pro Windungsschicht.

5. Sensor nach einem der vorherigen Ansprüche, **dadurch gekennzeichnet, dass** die Länge der Sekundärwicklung (32; 232; 432; 532), gemessen entlang der Längsachse (X), zwischen 2 mm und 60 mm, vorzugsweise zwischen 5 mm und 15 mm, ist.

6. Sensor nach Anspruch 2, **dadurch gekennzeichnet, dass** der Schließmechanismus (20; 220; 420; 520) ein Gehäuse (34; 234) umfasst, wobei eine minimale Breite (Lmin) des Gehäuses, gemessen radial zu der Längsachse (X), größer als 120 % des maximalen Durchmessers des mittleren Körpers (36; 236; 436; 536), gemessen radial zu der Längsachse (X), ist.

7. Sensor nach einem der vorherigen Ansprüche, **dadurch gekennzeichnet, dass** der Schließmechanismus (20; 220; 420; 520) ein Gehäuse (34; 234) umfasst, wobei das Gehäuse ein bewegliches Organ (52) umfasst, das geeignet ist, um, wenn der Schließmechanismus (20; 220; 420; 520) in der geschlossenen Position ist, zwischen einer Position zum Verriegeln der geschlossenen Position des Schließmechanismus (20; 220; 420; 520) und einer Position zum Entriegeln dieser Position verschoben zu werden.

8. Verfahren zur Herstellung eines Stromsensors (16; 216; 416; 516) mit Rogowski-Schleife, der dazu bestimmt ist, einen Strom zu messen, der in einem elektrischen Leiter fließt, das Herstellungsverfahren umfassend die folgenden Schritte:

   - Wickeln (104; 302) einer Hauptwicklung (22; 222; 422; 522) umfassend zwei Enden (42, 44; 242, 244; 442, 444; 542, 544),

   - Herstellen (100, 108, 110) eines Schließmechanismus (20; 220; 420; 520), der geeignet ist, um ein Ende (42; 242; 442; 542) mit dem anderen Ende (44; 244; 444; 544) zu verbinden, wobei der Schließmechanismus in Bezug auf eines der Enden (44; 244; 444; 544) zwischen einer geschlossenen Position und einer offenen Position bewegbar ist, in denen die Hauptwicklung (22; 222; 422; 522) und der Schließmechanismus (20; 220; 420; 520) eine geschlossene Schleife um den elektrischen Leiter (14) und jeweils eine offene Schleife bilden, wobei die zwei Enden (42, 44; 242, 244; 442, 444; 542, 544) in der geschlossenen Position des Schließmechanismus entlang einer Längsachse (X) des Schließmechanismus (20; 220; 420; 520) angeordnet und entlang der Längsachse (X) voneinander beabstandet sind, und

   - Wickeln (104; 308) einer Sekundärwicklung (32; 232; 432; 532), die in der geschlossenen Position des Schließmechanismus (20; 220; 420; 520) zwischen den Enden der Hauptwicklung (22; 222; 422; 522) angeordnet ist,

   wobei die Sekundärwicklung (32; 232; 432; 532) beim Schritt eines Wickelns (104; 308) der Sekundärwicklung eine Vielzahl von Windungen umfasst, die entlang der Längsachse (X) gegeneinander versetzt sind,

wobei der Durchmesser der Windungen der Sekundärwicklung (32; 232; 432; 532) größer als oder gleich wie der Durchmesser der Windungen der Hauptwicklung (22; 222; 422; 522) ist, **dadurch gekennzeichnet,**

**dass** in der geschlossenen Position des Schließmechanismus (20; 220) der entlang der Längsachse (X) gemessene Abstand zwischen jedem Ende und der Sekundärwicklung (32; 232; 432; 532) weniger als 1,5 mm ist, und **dass** die Sekundärwicklung (432; 532) entlang der Längsachse (X) einen Mittelabschnitt (432A; 532A) und einen ersten (432B; 532B) und einen zweiten (432C; 532C) distalen Abschnitt umfasst, und dass mindestens einer der distalen Abschnitte (432B, 432C; 532B, 532C) eine Anzahl von Windungen pro Längeneinheit umfasst, die größer ist als die Anzahl von Windungen pro Längeneinheit des Mittelabschnitts (432A; 532A),

wobei der entlang der Längsachse X gemessene Abstand zwischen einem Ende (442) der Hauptwicklung und einem Ende der Nebenwicklung (432) größer ist als 1 mm, und

wobei der entlang der Längsachse X gemessene Abstand zwischen dem anderen Ende (444) der Hauptwicklung und dem anderen Ende der Nebenwicklung (432) größer ist als 1 mm.

9. Verfahren nach Anspruch 8, **dadurch gekennzeichnet, dass**

    - der Schließmechanismus (20) in dem Herstellungsschritt (100, 108, 110) des Schließmechanismus (20) mit zwei Wicklungsverbindungsanschlüssen (60, 62) und einem mittleren Körper (36) hergestellt wird, um den die Sekundärwicklung (32) angeordnet werden soll.

10. Verfahren nach Anspruch 9, **dadurch gekennzeichnet, dass**

    - in den Schritten eines Wickelns (104) der Hauptwicklung und der Sekundärwicklung ein Draht kontinuierlich in einer ersten Richtung von einem der Verbindungsanschlüsse (60) aus gewickelt wird, um nacheinander die Sekundärwicklung (32) und die Hauptwicklung (22) zu bilden, und dass das letzte Ende (44) der gebildeten Hauptwicklung (22) mit dem anderen Verbindungsanschluss (62) verbunden ist.

11. Verfahren nach Anspruch 10, **dadurch gekennzeichnet, dass**, wenn das letzte Ende der Hauptwicklung (22) gebildet ist, der Draht kontinuierlich in eine zweite Richtung entgegengesetzt zu der ersten Richtung gewickelt wird, um die Anzahl der Windungen der Haupt- (22) und Sekundärwicklungen (32) zu erhöhen, und dann mit dem anderen Verbindungsanschluss (62) verbunden wird.

12. Verfahren nach Anspruch 8, **dadurch gekennzeichnet, dass**

    - in dem Schritt eines Wickelns (302) der Hauptwicklung (222) ein erster Draht gewickelt wird und die Hauptwicklung (222) bildet, wobei jedes ihrer Enden (242, 244) mit einem ersten (270) und einem zweiten (272) Wicklungsverbindungsanschluss verbunden ist,
    - der Schließmechanismus (220) in dem Herstellungsschritt (306, 312, 314) des Schließmechanismus (220) mit einem dritten (274) und einem vierten (276) Wicklungsverbindungsanschluss und einem mittleren Körper (236) hergestellt wird, um den die Sekundärwicklung (232) angeordnet werden soll,
    - in dem Schritt eines Wickelns (308) der Sekundärwicklung (232) ein zweiter Draht um den mittleren Körper (236) gewickelt wird und die Sekundärwicklung (232) zwischen dem dritten (274) und dem vierten (276) Verbindungsanschluss verbunden wird,

    und dass das Verfahren den folgenden Schritt umfasst:

    - Verbinden (312) des zweiten Verbindungsanschlusses (272) mit dem vierten Verbindungsanschluss (276).

## Claims

1. A Rogowski coil current sensor (16; 216; 416; 516) for measuring a current flowing in an electrical conductor (14), the current sensor comprising:

    - a main winding (22; 222; 422; 522) comprising two ends (42, 44, 242, 244; 442, 444; 542, 544),
    - a closing mechanism (20; 220; 420; 520) adapted to connect one end (42; 242; 442; 542) of the main winding to the other end (44; 244; 444; 544), the closing mechanism being movable relative to one of the ends (44; 244; 444; 544) between a closed position and an open position, wherein the main winding (22; 222; 422; 522) and the closing mechanism (20; 220; 420; 520) form a closed loop around the electrical conductor (14) and an open loop respectively, the two ends (42, 44; 242, 244; 442, 444; 542, 544) being, in the closed position of the closing mechanism, arranged along a longitudinal axis (X) of the closing mechanism (20; 220; 420; 520) and spaced apart from each other along the longitudinal axis (X), and

- a secondary winding (32; 232; 432; 532) arranged between the ends (42, 44; 242, 244; 442, 444; 542, 544) of the main winding (22; 222; 422; 522), in the closed position of the closing mechanism (20; 220; 420; 520),

the secondary winding (32; 232; 432; 532) comprising a plurality of turns offset from each other along the longitudinal axis (X), the diameter of the turns of the secondary winding (32; 232; 432; 532) being greater than or equal to the diameter of the turns of the main winding (22; 222; 422; 522), **characterised**

**in that**, in the closed position of the closing mechanism (20; 220), the distance measured along the longitudinal axis (X) between each end and the secondary winding (32; 232; 432; 532) is less than 1.5 mm, and

**in that** the secondary winding (432; 532) comprises, along the longitudinal axis (X), a central portion (432A; 532A) and first (432B; 532B) and second (432C; 532C) distal portions, and in that at least one of the distal portions (432B, 432C; 532B, 532C) comprises a greater number of turns per unit of length than the number of turns per unit of length of the central portion (432A; 532A),

the distance measured along the longitudinal axis X between one end (442) of the main winding and one end of the secondary winding (432) being greater than 1 mm, and

the distance measured along the longitudinal axis X between the other end (444) of the main winding and the other end of the secondary winding (432) being greater than 1 mm.

2. The sensor according to claim 1, **characterised in that** the closing mechanism comprises a central body (36; 236; 436; 536) around which the secondary winding (32; 232; 432; 532) is arranged along the longitudinal axis (X).

3. The sensor according to one of the preceding claims, **characterised in that** the main winding (22; 222; 422; 522) is electrically connected in series with the secondary winding (32; 232; 432; 532).

4. The sensor according to one of the preceding claims, **characterised in that** the number of turns per unit of length of the secondary winding (32; 232; 432; 532) is between 0.1 and 25 turns per millimetre for each layer of turns, preferably between 0.5 and 3 turns per millimetre for each layer of turns.

5. The sensor according to one of the preceding claims, **characterised in that** the length of the secondary winding (32; 232; 432; 532), measured along the longitudinal axis (X), is between 2 mm and 60 mm, preferably between 5 mm and 15 mm.

6. The sensor according to claim 2, **characterised in that** the closing mechanism (20; 220; 420; 520) comprises a housing (34; 234), a minimum width (Lmin) of the housing, measured radially to the longitudinal axis (X), being greater than 120% of the maximum diameter of the central body (36; 236; 436; 536), measured radially to the longitudinal axis (X).

7. The sensor according to one of the preceding claims, **characterised in that** the closing mechanism (20; 220; 420; 520) comprises a housing (34; 234), the housing comprising a movable member (52) adapted to be moved, when the closing mechanism (20; 220; 420; 520) is in a closed position, between a position of locking the closed position of the closing mechanism (20; 220; 420; 520) and a position of unlocking said position.

8. A method of manufacturing a Rogowski coil current sensor (16; 216; 416; 516) for measuring a current flowing in an electrical conductor, the manufacturing method comprising the following steps:

- the coiling (104, 302) of a main winding (22; 222; 422; 522) comprising two ends (42, 44; 242, 244; 442, 444; 542, 544),
- the manufacturing (100, 108, 110) of a closing mechanism (20; 220; 420; 520) adapted to connect one end (42; 242; 442; 542) to the other end (44; 244; 444; 544), the closing mechanism being movable relative to one of the ends (44; 244; 444; 544) between a closed position and an open position, wherein the main winding (22; 222; 422; 522) and the closing mechanism (20; 220; 420; 520) form a closed loop around the electrical conductor (14) and an open loop respectively, the two ends (42, 44; 242, 244; 442, 444; 542, 544) being, in the closed position of the closing mechanism, arranged along a longitudinal axis (X) of the closing mechanism (20; 220; 420; 520) and spaced apart from each other along the longitudinal axis (X), and
- the coiling (104; 308) of a secondary winding (32; 232; 432; 532), arranged between the ends of the main winding (22; 222; 422; 522), in the closed position of the closing mechanism (20; 220; 420; 520),

during the step of coiling (104; 308) the secondary winding, the secondary winding (32; 232; 432; 532) comprises a plurality of turns offset from each other along the longitudinal axis (X), the diameter of the turns of the secondary winding (32; 232; 432; 532) being greater than or equal to the diameter of the turns of the main winding (22; 222; 422; 522), **characterised**

**in that**, in the closed position of the closing mechanism (20; 220), the distance measured along the longitudinal axis (X) between each end and the secondary winding (32; 232; 432; 532) is less than 1.5 mm, and

**in that** the secondary winding (432; 532) comprises, along the longitudinal axis (X), a central portion (432A; 532A) and first (432B; 532B) and second (432C; 532C) distal portions, and in that at least one of the distal portions (432B, 432C; 532B, 532C) comprises a greater number of turns per unit of length than the number of turns per unit of length of the central portion (432A; 532A),

the distance measured along the longitudinal axis X between one end (442) of the main winding and one end of the secondary winding (432) being greater than 1 mm, and

the distance measured along the longitudinal axis X between the other end (444) of the main winding and the other end of the secondary winding (432) being greater than 1 mm.

9. The method according to claim 8, **characterised in that**,

- during the step of manufacturing (100, 108, 110) the closing mechanism (20), the closing mechanism (20) is manufactured with two coiling connection terminals (60, 62) and a central body (36) around which the secondary winding (32) is intended to be arranged.

10. The method according to claim 9, **characterised in that**,

- during the steps of coiling (104) the main winding and the secondary winding, a wire is continuously wound in a first direction from one of the connection terminals (60) to form the secondary winding (32) and the main winding (22) in succession, and **in that** the last end (44) of the main winding (22) formed is connected to the other connection terminal (62).

11. The method according to claim 10, **characterised in that** when the last end of the main winding (22) is formed, the wire is continuously wound in a second direction, opposite to the first direction, to increase the number of turns of the main (22) and secondary (32) windings, and then connected to said other connection terminal (62).

12. The method according to claim 8, **characterised in that**,

- during the step of coiling (302) the main winding (222), a first wire is wound and forms the main winding (222) with each of its ends (242, 244) connected to a first (270) and a second (272) coiling connection terminal,

- during the step of manufacturing (306, 312, 314) the closing mechanism (220), the closing mechanism (220) is manufactured with third (274) and fourth (276) coiling connection terminals and a central body (236) around which the secondary winding (232) is intended to be arranged,

- during the step of coiling (308) the secondary winding (232), a second wire is wound around the central body (236), and the secondary winding (232) is connected between the third (274) and fourth (276) connection terminals,

and **in that** the method comprises the following step:

- the connection (312) of the second connection terminal (272) with the fourth connection terminal (276).

FIG.1

FIG.2

FIG.3

**FIG.4**

**FIG.5**

```
┌─────────────────────────┐
│  Fabrication corps central │ ──── 100
└─────────────────────────┘
            │
            ▼
┌─────────────────────────┐
│  Fixation du support de bobinage │ ──── 102
│  au mécanisme de fermeture │
└─────────────────────────┘
            │
            ▼
┌─────────────────────────┐
│  Bobinage de l'enroulement principal │ ──── 104
│  et de l'enroulement secondaire │
└─────────────────────────┘
            │
            ▼
┌─────────────────────────┐
│  Assemblage de la gaine, de l'embout │ ──── 106
│  et du tore de maintien │
└─────────────────────────┘
            │
            ▼
┌─────────────────────────┐
│  Connexion du circuit intégré │ ──── 108
│  aux bornes de connexion │
└─────────────────────────┘
            │
            ▼
┌─────────────────────────┐
│  Fixation du boîtier │ ──── 110
└─────────────────────────┘
```

## FIG.6

## FIG.7

FIG.8

FIG.9

FIG.10

FIG.12

Fixation de l'élément de connexion
au support de bobinage

300

↓

Bobinage de l'enroulement principal

302

↓

Assemblage de la gaine
et de l'embout sur le support

304

↓

Fabrication du corps central

306

↓

Bobinage de l'enroulement secondaire

308

↓

Assemblage du corps principal
et du corps central

310

↓

Connexion du circuit intégré
aux bornes de connexion

312

↓

Fixation du boîtier

314

FIG.11

532B 532 532A 520 532C

516

522 542

544

524

536

X

X

**FIG.13**

## RÉFÉRENCES CITÉES DANS LA DESCRIPTION

**Documents brevets cités dans la description**

- EP 2009453 A1
- WO 2005119274 A1
- US 4799005 A
- JP 2003139802 A
- JP 2011252751 A